Europäisches Patentamt

European Patent Office

Office européen des brevets

(11) Publication number : **0 505 324 A1**

(12) **EUROPEAN PATENT APPLICATION**

(21) Application number : 92830043.3

(22) Date of filing : 04.02.92

(51) Int. Cl.⁵ : **G01R 23/10, H03K 21/12**

(30) Priority : **15.02.91 IT 11091**

(43) Date of publication of application :
**23.09.92 Bulletin 92/39**

(84) Designated Contracting States :
**DE ES FR GB SE**

(71) Applicant : **MARELLI AUTRONICA S.p.A.**
**Via Griziotti 4**
**I-20145 Milano (IT)**

(72) Inventor : **Ghisio, Guido**
**Via Bastone 90**
**I-10090 Rosta (Torino) (IT)**
Inventor : **Redivo, Paola**
**Via Monte Pasubio 8**
**I-11100 Aosta (IT)**
Inventor : **Catena, Maurizio**
**Via Almese 92**
**I-10093 Collegno (Torino) (IT)**

(74) Representative : **Quinterno, Giuseppe et al**
**c/o Jacobacci-Casetta & Perani S.p.A. Via**
**Alfieri, 17**
**I-10121 Torino (IT)**

(54) **Device for counting and storing the number of pulses of a signal within a time interval.**

(57) The device includes first and second counters (S ; D) the changes of the output data ($s_1...s_n$ ; $d_1...d_n$) of which correspond to leading edges ($a_s$) and trailing edges ($a_d$) respectively of the signal (A) whose pulses are to be counted, and control devices (FF, M) for detecting the level of the signal (A) when a switching edge (e), which defines the end of the counting period, occurs in a second signal (B). The control devices (FF, M) are adapted to transfer to a memory register (R) the data output by the first counter (S) if the first signal (A) is at a "high" level when the edge occurs in the second signal (B) and the data output by the second counter (D) if the first signal (A) is at a "low" level when the edge occurs in the second signal (B).

FIG. 2

EP 0 505 324 A1

The present invention relates to a device for counting and storing the number of pulses of a first signal at the end of a time interval defined by a switching edge of a second signal which is not synchronous with the first.

More specifically, the subject of the invention is a device comprising:

– counting means for receiving the first signal, and

– memory means intended to receive the second signal and connected to the outputs of the counter means so as to acquire the data output by the counter means as a result of a said edge in the second signal, the acquisition of the data requiring a period of time shorter than the minimum duration of the pulses of the first signal.

There is sometimes a problem in detecting the number of pulses of a signal within a period of time defined by a second, logic-type signal which is not synchronous with the pulses of the first in circumstances in which no clock signal is available for synchronising the pulses of the first signal with the second signal.

One solution to this problem may be to send the pulses of the first signal to a counter whose outputs are connected to the inputs of a memory register which receives a command to read when a switching edge occurs in the second signal. The disadvantage of this solution lies in the fact that the reading of the outputs of the counter may take place at the same time as a change in the output states of the counter caused by a pulse of the first signal. In this situation, the data transferred to the memory register by the counter could be erroneous, not so much because there may or may not have been a change in the output states of the counter, but rather due to the fact that, because of delays in the propagation of the signal within the structure of the counter and because of the lack of uniformity of the switching delays in the various cells which form the counter, the data read may not be significant since they relate to a changing situation (for example, the least significant bit could already have changed its state but a more significant bit might not yet have changed) and may be unstable.

The object of the invention is to propose a counting and storage device which can detect the number of pulses of a signal under the conditions indicated above, particularly when a synchronising (clock) signal is not available, and can supply an indication of the pulses counted with an error of at most ± 1/2 pulse.

According to the invention, this object is achieved by a counting and storage device of the type specified above, whose main characteristic lies in the fact that the counter means comprise first and second counters the changes of the output data of which correspond respectively to leading edges and trailing edges of the first signal, the device also including control means for detecting the level of the first signal when a switching edge occurs in the second signal and transferring to the memory means the data output by the first counter if the first signal is at a "high" level and the data output by the second counter if the first signal is at a "low" level.

Further characteristics and advantages of the invention will become clear from the detailed description which follows with reference to the appended drawings provided purely by way of non-limiting example, in which:

Figure 1 is a graph showing by way of example the shape of a first signal whose pulses within a certain time interval are to be counted and the shape of a second signal which defines the time interval, and

Figure 2 is a circuit diagram of an embodiment of a counting and storage device according to the invention.

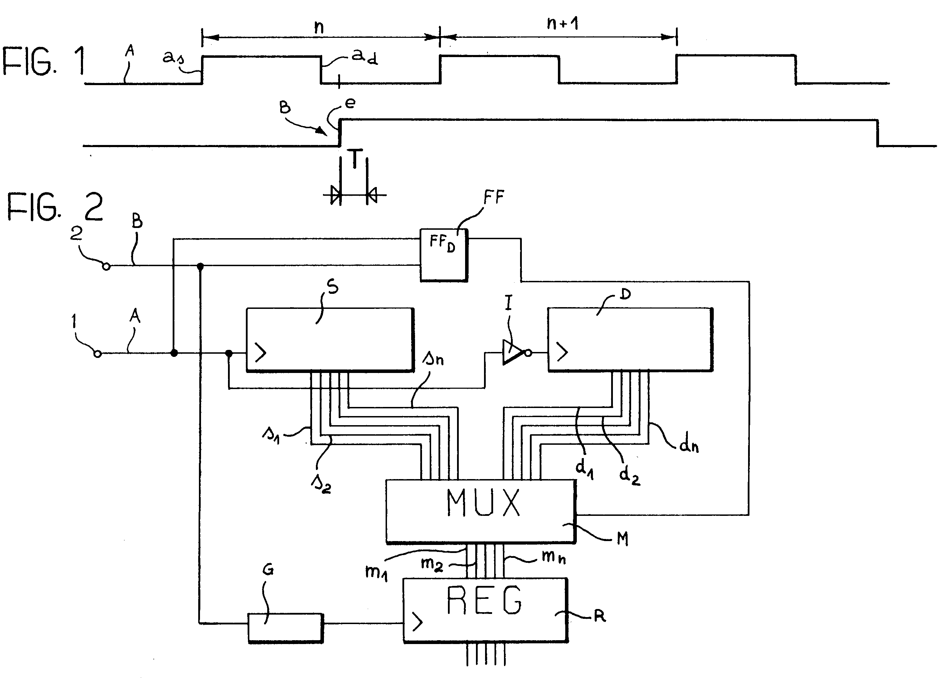

Figure 1 of the appended drawings shows, by way of example, the shape of a first two-level signal, indicated A. In the example illustrated, the signal is periodic and has a duty cycle of 50%. As will become clear from the following, the invention does not necessarily apply only to signals having these characteristics.

In particular, Figure 1 shows two successive periods of the signal A, indicated n and n+1, respectively.

The signal A is the signal whose pulses within a period of time are to be counted, the end of the period being defined by a switching edge $\underline{e}$ of a second signal, indicated B in Figure 1. In the example shown in the graph, the edge $\underline{e}$ of the signal B is a leading edge. In general, this leading edge may occur whilst the signal A is at a "high" level or at a "low" level.

In order to count the pulses of the signal A which fall within a time interval whose end corresponds to the edge $\underline{e}$ of the signal B, according to the invention, a device having the structure shown by way of example in Figure 2 is used. This device has two input terminals 1, 2 for receiving the signals A and B respectively. The terminal 1 is connected to the input of a counter S and, through an inverter I, to the input of another counter D structurally identical to S.

The counter S is arranged to change its output data $s_1, s_2, ...s_n$ with each leading edge $a_s$ of the signal A. Correspondingly, the counter D changes its output data $d_1, d_2, ...d_n$ with each trailing edge $a_d$ of the signal A.

The outputs of the counters S and D are connected to the inputs of a multiplexer M whose outputs $m_1, m_2, ...m_n$ are connected in order to the inputs of a memory register R.

The input terminal 2 of the counting and storage device is connected to the clock input of a D-type flip-flop circuit, indicated FF in Figure 2. The data input of this bistable circuit is connected to the terminal 1 and is thus intended to receive the signal A.

The output of the circuit FF is connected to the control input of the multiplexer M.

The arrangement described above is such that, if the signal A is at a "high" level (level "1") when a leading edge e occurs in the signal B, the multiplexer M outputs the data output by the counter S . If the signal A is at a "low" level (level "0") when an edge e occurs in the signal B, however, the multiplexer M outputs the data output by the counter D.

In other words, the counter S or D from which the data concerning the number of pulses of the signal A is to be taken is selected on the basis of the result of the sampling of the signal A when a leading edge e occurs in the signal B.

If the signal A is at level "1" when an edge e occurs, the chance of the next switching of the signal A being a switch from "0" to "1" is nil. In these circumstances, if the data are taken from the counter S (by the multiplexer M), stable data are certain to be obtained since the counter S counts only when the signal A changes from "0" to "1".

If the signal A is at level "0" when an edge occurs in the signal B, on the other hand, the chance of the next switching of the signal A being from "1" to "0" is nil. In these circumstances, the storage of stable data in the register R is ensured if the data are taken from the counter D whose output changes only when the signal A changes from "1" to "0".

If the edge e in the signal B, and hence the sampling of the level of the signal A, occurs simultaneously with a change in the level of the signal A, the result of the sampling of the signal A may be uncertain and will depend on the temperature, the supply voltage, and other parameters and on the characteristics of the devices used. In these particular circumstances it is not possible to determine beforehand which of the two counters S and D will be selected by the multiplexer M. The data supplied by the counter S or D selected, however, are sure to be stable when they are stored in the register R, precisely because the level of the signal A has already switched during the sampling stage. Conveniently, this storage is controlled by a signal obtained from the signal B suitably delayed by a delay circuit, indicated G in Figure 2. The necessary delay corresponds to the time which elapses between a switch in the level of the signal A (which in the worst case coincides with the change in level of the signal B) and the time at which the data produced by the counter are stabilised.

The device described can thus guarantee the precision of the data acquired, which is characterised by an accuracy of ± half a bit, any error being due mostly to the asynchronous relationship between the signals A and B rather than to an intrinsic inaccuracy of the detection.

The counting is started by a logic starter circuit of known type, not shown, in a manner such that the counter S is updated first, followed by the counter D.

The counting and storage device described above not only solves the problem described at the beginning but also affords advantages compared with solutions which use a service clock signal to synchronise the signals A and B.

In fact, solutions with synchronising clock signals lead to delayed storage because of the intrinsic delay introduced by the synchronising signal or to the storage of data which have not been updated. Both of these problems can be completely avoided with the device according to the invention.

Naturally, the principle of the invention remaining the same, the forms of embodiment and details of construction may be varied widely with respect to those described and illustrated purely by way of non-limiting example, without thereby departing from the scope of the present invention.

## Claims

1. A device for counting and storing the number of pulses of a first signal (A) within a time interval whose end is defined by a switching edge (e) of a second signal (B) which is not synchronous with the first signal (A), the device including:
   – counter means (S, D) for receiving the first signal (A), and
   – memory means (R) intended to receive the second signal (B) and connected to the outputs of the counter means (S, D) so as to acquire the data output by the counter means (S, D) as a result of a said edge (e) in the second signal (B), the acquisition of the data requiring a period of time (T) shorter than the minimum duration of the pulses of the first signal (A), characterised in that the counter means comprise first and second counters (S; D) the changes of the output data ($s_1,...s_n$; $d_1...d_n$) of which correspond respectively to leading edges ($a_s$) and trailing edges ($a_d$) of the first signal (A), the device also including control means (FF, M) for detecting the level of the first signal (A) when a switching edge (e) occurs in the second signal (B) and transferring to the memory means (R) the data output by the first counter (S) if the first signal (A) is at a "high" level when the edge occurs in the second signal (B) and the data output by the second counter (D) if the first signal (A) is at a "low" level when the edge occurs in the second signal (B).

2. A device according to Claim 1, characterised in that the control means comprise a multiplexer (M) interposed between the outputs of the first and second counters (S, D) and the inputs of the memory means (R).

3. A device according to Claim 2, characterised in that the control means include a D-type bistable circuit (FF) a first input of which receives the first signal (A) and the clock input of which receives the second signal (B), the output of the bistable circuit (FF) being connected to a control input of the multiplexer (M).

4. A device according to any one of the preceding claims, characterised in that a delay circuit (G) is connected upstream of the input of the memory means which is intended to receive the second signal (B).

5. A device according to any one of Claims 1 to 4, characterised in that the counters (S, D) are identical and in that an inverter (I) is connected upstream of the synchronising input of one of them.

FIG. 1

FIG. 2

EP 0 505 324 A1

**European Patent Office**

**EUROPEAN SEARCH REPORT**

Application Number

EP 92 83 0043

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | US-A-3 922 670 (SHAW)<br>--- | 1,6 | G 01 R  23/10<br>H 03 K  21/12 |
| A | FR-A-2 370 263 (WESTINGHOUSE)<br>--- | | |
| A | US-A-3 541 312 (NASA)<br>----- | | |

TECHNICAL FIELDS
SEARCHED (Int. Cl.5)

G 01 R
H 03 K

The present search report has been drawn up for all claims

| Place of search | Date of completion of the search | Examiner |
|---|---|---|
| THE HAGUE | 12-06-1992 | HOORNAERT W. |

EPO FORM 1503 03.82 (P0401)